Europäisches Patentamt

European Patent Office

Office européen des brevets

(11) Veröffentlichungsnummer: 0 285 047

A2

# (12) EUROPÄISCHE PATENTANMELDUNG

(21) Anmeldenummer: 88104922.5

(22) Anmeldetag: 26.03.88

(51) Int. Cl.⁴ **H03K 12/00** , H03K 5/08

(30) Priorität: **01.04.87 DE 3710871**

(43) Veröffentlichungstag der Anmeldung:
**05.10.88 Patentblatt 88/40**

(84) Benannte Vertragsstaaten:
**BE DE FR GB SE**

(71) Anmelder: **Standard Elektrik Lorenz Aktiengesellschaft**
**Lorenzstrasse 10**
**D-7000 Stuttgart 40(DE)**

(84) **DE**

(71) Anmelder: **Alcatel N.V.**
**Strawinskylaan 537 (World Trade Center)**
**NL-1077 XX Amsterdam(NL)**

(84) **BE FR GB SE**

(72) Erfinder: **Löwel, Helmut**
**Preysingstrasse 6**
**D-8500 Nürnberg(DE)**

(74) Vertreter: **Hösch, Günther, Dipl.-Ing. et al**
**Standard Elektrik Lorenz AG Patent- und**
**Lizenzwesen Postfach 30 09 29**
**D-7000 Stuttgart 30(DE)**

(54) Schaltung zur Formung einer Messsignalspannung in ein Rechtecksignal.

(57) Zur Erzeugung eines stabilen Rechtecksignals aus einer an einem Spannungsteiler abgegriffenen Meßsignalspannung, die einen Gleichspannungsanteil und einen Wechselspannungsanteil enthält, wird der Fußpunkt (17) des Spannungsteilers (1) über einen Arbeitswiderstand (18) nach Masse geschaltet und parallel zum Arbeitswiderstand (18) die Reihenschaltung eines Widerstandes (19) und eines nach Masse geschalteten Kondensators (22) angeschlossen. Weiterhin ist der Fußpunkt (17) über den Widerstand (19) mit dem negativen Eingang (20) eines Komparators (21) und über einen weiteren Widerstand (23) mit dem positiven Eingang (24) des Komparators (21) verbunden und der Eingang (24) ist über einen Rückkopplungswiderstand (26) mit dessen Ausgang (25) verbunden. Außerdem liegt der Fußpunkt (17) über einen zweiten Spannungsteiler (6) an der Versorgungsspannung ($U_V$) an, dessen erster Teilerwiderstand aus einer steuerbaren temperaturstabilisierten Zenerdiode (5) besteht, die über den zweiten Teilerwiderstand (4) an der Versorgungsspannung ($U_V$) liegt und an deren Steuerelektrode (8) die am Teilerpunkt (7) des ersten Spannungsteilers (1) abgegriffene Meßsignalspannung ($U_M$) liegt.

Fig.1

## Schaltung zur Formung einer Meßsignalspannung in ein Rechtecksignal.

Die vorliegende Erfindung bezieht sich auf eine Schaltung zur Formung einer Meßsignalspannung in ein Rechtecksignal gemäß dem Oberbegriff des Anspruchs 1.

Eine derartige Schaltung ist aus der Zeitschrift Elektronik, Heft 10 vom 17.05.1985, Seite 100 bekannt. Zur Formung des Meßsignals in ein Rechtecksignal wird dort ein als Schmitt-Trigger geschalteter Operationsverstärker verwendet. An dessen positivem Eingang liegt das verstärkte Meßsignal an und am anderen, negativen Eingang liegt die Versorgungsspannung. Letztere wird dort als konstant vorausgesetzt. Bei dieser Anordnung muß also eine stabilisierte Versorgungsspannung vorhanden sein. Beim Meßsignal selbst werden Fehler druch Temperaturänderung der Bauteile ausgeregelt, indem ein Spannungsteiler mit einem temperaturabhängigen Widerstand mit positivem Temperaturkoeffizienten vorgesehen ist, dessen Teilerpunkt an einem Eingang eines Operationsverstärkers angeschlossen ist. Dadurch erhält man eine temperaturgesteuerte Stromquelle für einen Sensor, dessen Meßsignalspannung geformt werden soll. Bei einem Verstärker-Operationsverstärker werden außerdem zur Temperaturkompensation in den Zuleitungen zu den Eingängen ansonsten nicht notwendige Widerstände eingeschaltet.

Mit der vorliegenden Erfindung soll die Aufgabe gelöst werden, eine fehlerkorrigierte Rechteckausgangsspannung ohne großen Schaltungsaufwand und mit möglichst kleinen Bauteilen realisieren zu können.

Gelöst wird diese Aufgabe durch die im Kennzeichen des Anspruchs 1 angegebenen Merkmale. Durch diese Maßnahmen ist keine stabilisierte Versorgungsspannung notwendig und eine besondere Temperaturregelung ist ebenfalls nicht erforderlich.

Weitere vorteilhafte Einzelheiten der Erfindung sind in den Unteransprüchen angegeben und nachfolgend anhand eines in der Zeichnung veranschaulichten Ausführungsbeispiels beschrieben.

Es zeigen:

Fig. 1 eine Schaltung mit einem R-C-Glied am ersten Spannungsteiler,

Fig. 2 die Anordnung der magnetfeldabhängigen Widerstände relativ zu den Zähnen eines Zahnrades oder einer Zahnstange und

Fig. 3 das Diagramm eines verstärkten Meßsignals und das daraus abgeleitete Rechtecksignal.

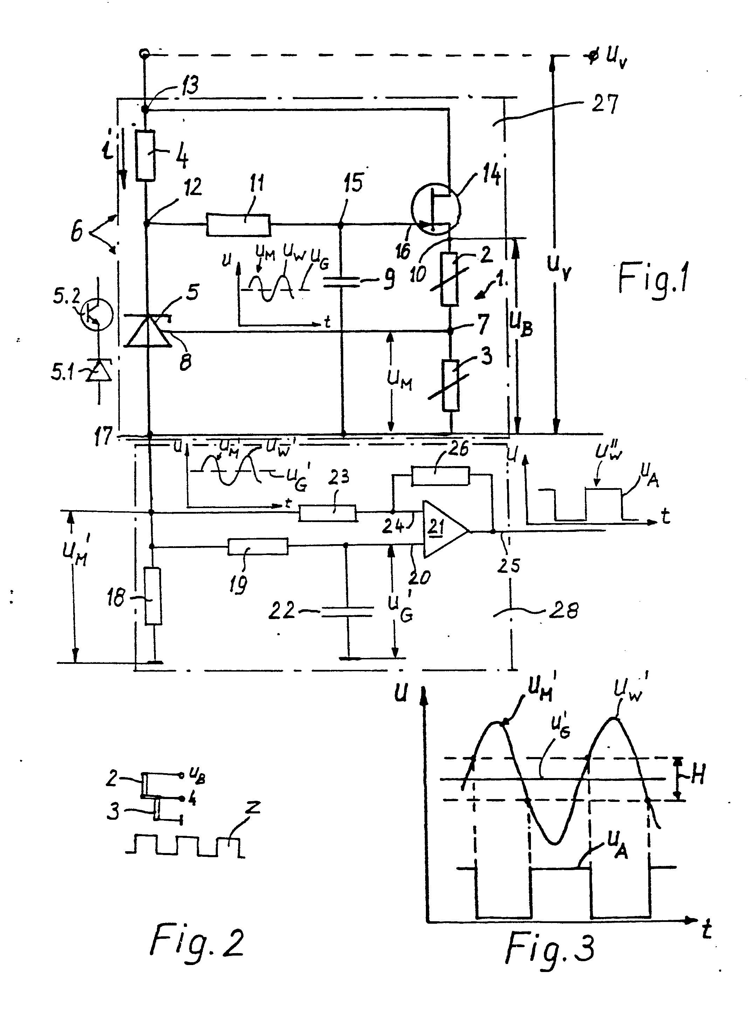

Mit 1 ist ein Spannungsteiler aus zwei magnetfeldabhängigen Widerständen 2 und 3 bezeichnet. Sie sind beispielsweise bei gleicher Zahnung um einen viertel Zahnabstand gegeneinander versetzt angeordnet, wie in der Skizze von Fig. 2 dargestellt. Der Spannungsteiler 1 kann auch nur einen einzigen magnetfeldabhängigen Widerstand und einen ohmschen Widerstand aufweisen. Er erhält seine Betriebsspannung $U_B$ über einen Vorwiderstand 14 von einer Versorgungsspannung $U_V$.

Parallel zum Spannungsteiler 1 ist eine steuerbare Impedanz 5, insbesondere eine steuerbare Zenerdiode, z.B. der IC-Typ TL 431 oder, wie neben der Fig. 1 abgebildet, eine Reihenschaltung aus einer Zenerdiode 5.1 und einem Längstransistor 5.2, geschaltet, die mit dem Vorwiderstand 4 einen zweiten Spannungsteiler 6 bildet. Der Teilerpunkt 7 des ersten Spannungsteilers 1 ist mit dem Steuereingang 8 der steuerbaren Impedanz 5 verbunden. Zum ersten Spannungsteiler 1 liegt noch ein Kondensator 9 parallel und vom Hochpunkt 10 des Spannungsteilers 1 ist ein Widerstand 11 zum Teilerpunkt 12 des Spannungsteilers 6 geschaltet. Der Widerstand 11 bildet mit dem Kondensator 9 ein Zeitglied, dessen Zeitkonstante größer, insbesondere fünf-bis zwanzigmal größer ist als die niedrigste am Teilerpunkt 7 des Spannungsteilers 1 auftretende Frequenz des Wechselspannungsanteils $U_W$.

Bei Verwendung der integrierten steuerbaren Impedanz des genannten Typs TL 431 werden Änderungen der Werte der Schaltung, z.B. Temperaturänderungen oder Alterungen und damit Widerstandsänderungen der magnetfeldabhängigen Widerstände 2 und 3 oder der weiteren Schaltungsbauteile, ausgeglichen, da dieser Schaltkreis eine interne Temperaturkompensation enthält. Das erreichbare Ausgangssignal ist daher sehr stabil.

Um mit kleinen Abmessungen und damit kleinen Kapazitätswerten auszukommen, ist gemäß der Erfindung vom Hochpunkt 10 des ersten Spannungsteilers 1 zum Hochpunkt 13 des Vorwiderstandes 4 bzw. zur Versorgungsspannung $U_V$ die Drain-Source-Strecke eines Feldeffekttransistors 14 geschaltet und der Verbindungspunkt 15 des Kondensators 9 mit dem Widerstand 11 ist an die Steuerelektrode 16 angeschlossen und damit über die sehr hochohmige Steuerstecke des Feldeffekttransistors 14 mit dem Hochpunkt 10 verbunden. Der Feldeffekttransistor 14 wirkt als Impedanzwandler und hält den Hochpunkt 10 auf konstantem Potential. Durch den sehr hohen Eingangswiderstand des Feldeffekttransistors 14 fließen in der Steuerstrecke nur ganz geringe Ströme, beispielsweise in der Größenordnung von einigen Pikoampère. Dadurch kann der Kondensator 9 sehr klein gemacht werden. Bei einem Ausführungsbeispiel lag der Widerstandswert des Widerstandes 11 beispielsweise in der Größenordnung von 10 MOhm bis zu einigen 10 MOhm und der Kapazitätswert des Kondensators 9 lag in der Größenordnung von 100 nF.

Von besonderem Vorteil ist der Aufbau der Schaltung mit wenigen kleinen Bauteilen, die in einer baulichen Einheit zusammengefaßt und in einem gemeinsamen Gehäuse untergebracht sind, das mit lediglich zwei Zuleitungen versehen ist. Die Bauteile 18 bis 26 werden in einer zweiten Einheit vorgesehen. Diese Einheit kann leicht an beliebigen Stellen angebracht werden.

Die Wirkungsweise der Schaltung ist wie folgt:

Die beiden magnetfeldabhängigen Widerstände 2, 3 bewegen sich relativ zu einem ferromagnetischen Zahnrad oder einer Zahnstange Z etc., das bzw. die selbst magnetisiert sein kann bzw. sein können. Bei nichtmagnetisiertem Zahnrad oder einer Zahnstange sind den magnetfeldabhängigen Widerständen in bekannter Weise ein Permanentmagnet zugeordnet, dessen Magnetfeld die magnetfeldabhängigen Widerstände durchsetzt und dessen Richtung in den magnetfeldabhängigen Widerständen durch das äußere ferromagnetische Teil verändert und damit deren Widerstand ebenfalls verändert wird. Beim Vorbeibewegen der Zähne des Zahnrades Z an den um einen viertel Zahnabstand gegeneinander versetzten magnetfeldabhängigen Widerständen 2, 3 erhöht sich z.B. der Widerstandswert des einen magnetfeldabhängigen Widerstandes 2 und erniedrigt sich derjenige des anderen magnetfeldabhängigen Widerstandes 3 und umgekehrt periodisch von einem gleichen Normwert aus. Hierdurch erhält man am Teilerpunkt 7 ein Meßsignal $U_M$, das aus einem mit einem Wechselspannungsanteil $U_W$ überlagerten Gleichspannungsanteil $U_G$ besteht. Das Meßsignal $U_M$ steuert die Impedanz 5 derart, daß bei sinkender Spannung am Teilerpunkt 7 die Spannung am Teilerpunkt 12 ansteigt. Ohne Kondensator 9 und Widerstand 11 würde dies eine Erhöhung der Betriebsspannung $U_B$ am ersten Spannungsteiler 1 bedingen, bis die Spannung am Teilerpunkt 7 der Referenzspannung des Steuereingangs der steuerbaren Impedanz 5 entspricht. Bei dem angegebenen Typ TL 431 sind dies 2,5 V.

Infolge der hohen Zeitkonstante des R-C-Gliedes 9, 11 in Verbindung mit der hochohmigen Steuerstrecke des Feldeffekttransistors 14 wirkt sich die Impedanzänderung der Impedanz 5 nicht am ersten Spannungsteiler 1 aus, es findet also keine Regelung statt. Hierdurch wird durch die Impedanzänderung des zweiten Spannungsteilers 6 der durch ihn fließende Strom verändert und damit eine Verstärkung des Meßsignals $U_M$ erreicht.

Von dem mit der Anode der steuerbaren Zenerdiode 5 verbundenen Fußpunkt 17 des ersten Spannungsteilers 1 ist ein Arbeitswiderstand 18 nach Masse geschaltet. Dieser Arbeitswiderstand 18 ist extern an beliebigen Stellen anbringbar, wenn die vorgenannte Schaltung zu einer baulichen Einheit zusammengefaßt ist. Zu der Schaltung führen daher nur zwei Leitungen, nämlich die Verbindungsleitung des Arbeitswiderstandes 18 zum Fußpunkt 17 und die Versorgungsspannung $U_V$.

Um aus dem am Fußpunkt 17 abnehmbaren verstärkten Maßsignal $U_M'$ ein Rechtecksignal als Ausgangsspannung $U_A$ zu erhalten, ist der Fußpunkt 17 über einen Widerstand 19 am negativen Eingang 20 eines als Komparator geschalteten Operationsverstärkers 21 angeschlossen und der Eingang 20 über einen Kondensator 12 nach Masse geschaltet. An diesem steht daher der Gleichspannungsanteil $U_G'$ an. Weiterhin ist der Fußpunkt 17 über einen Widerstand 23 mit dem positiven Eingang 24 des Operationsverstärkers 21 verbunden. An letzterem ist ein mit dem Ausgang 25 des Operationsverstärkers 21 verbundener Rückkopplungswiderstand 26 angeschlossen. Je nach Wahl der Widerstände 23 und 26 sind die Schwellwertspannungen des als Komparator geschalteten Operationsverstärkers 21 und damit dessen Hysterese H festgelegt, so daß durch Vergleich der verstärkten Meßsignalspannung $U_M'$ mit deren Gleichspannungsanteil $U_G'$ eine temperaturstabilisierte Rechteckspannung $U_W''$ als Ausgangssignalspannung $U_A$ am Ausgang 25 des Operationsverstärkers 21 zur Verfügung steht.

Zur Erzielung eines sehr stabilen Rechteck-Ausgangssignals $U_A$ ist daher sowohl zur Erzeugung der verstärkten Meßsignalspannung $U_M'$ als auch zur Erzeugung der Rechteckspannung $U_A$ nur je ein ggf. getrennter Schaltkreis 27 bzw. 28 mit wenigen Bauteilen und mit kleinem Bauvolumen erforderlich.

**Ansprüche**

1. Schaltung zur Formung einer an einem Spannungsteiler abgegriffenen Meßsignalspannung, die einen Gleichspannungsanteil und einen Wechselspannungsanteil enthält, in ein Rechtecksignal, **dadurch gekennzeichnet**, daß der Fußpunkt (17) des Spannungsteilers (1) über einen Arbeitswiderstand (18) nach Masse geschaltet ist, daß parallel zum Arbeitswiderstand (18) die Reihenschaltung eines Widerstandes (19) und eines nach Masse geschalteten Kondensators (22) angeschlossen ist, daß der Fußpunkt (17) über den Widerstand (19) mit dem negativen Eingang (20) eines Komparators (21) und über einen weiteren Widerstand (23) mit dem positiven Eingang (24) des Komparators (21) verbunden ist und der Eingang (24) über einen Rückkopplungs-Widerstand (26) mit dem Ausgang (25) des Komparators (21) verbunden ist, und daß der Fußpunkt (17) über einen zweiten Spannungsteiler (6) an der Versorgungsspannung (U_V) liegt, dessen erster Teilerwiderstand aus einer steuerbaren temperaturstabilisierten Zenerdiode (5) besteht, die über den zweiten Teilerwiderstand (4) an der Versorgungsspannung (U_V) liegt und an deren Steuerelektrode (8) die am Teilerpunkt (7) des ersten Spannungsteilers (1) abgegriffene Meßsignalspannung (U_M) liegt.

2. Schaltung nach Anspruch 1, dadurch gekennzeichnet, daß einer oder beide Teilerwiderstände (2 und/oder 3) des ersten Spannungsteilers aus einem magnetfeldabhängigen Widerstand besteht bzw. bestehen, daß der Spannungsteiler (1) mit dem Hochpunkt (10) über einen Widerstand (11) am Teilerpunkt (12) des zweiten Spannungsteilers (6) liegt und zwischen Hochpunkt (10) und Fußpunkt (17) ein Kondensator (9) angeschlossen ist, und daß der Widerstand (11) und der Kondensator (9) ein Zeitglied bilden, deren Zeitkonstante wesentlich größer ist als die Periodendauer der niedrigsten auftretenden Frequenz des Wechselspannungsanteils (U_W) des Meßsignals (U_M).

3. Schaltung nach Anspruch 2, dadurch gekennzeichnet, daß der Hochpunkt (10) des ersten Spannungsteilers (1) über die Drain-Source-Strecke eines Feldeffekttransistors (14) an die Versorgungsspannung (U_V) und der Verbindungspunkt (15) von Widerstand (11) und Kondensator (9) an die Steuerelektrode (16) des Feldeffekttransistors (14) angeschlossen ist.

Fig.1

Fig.2

Fig.3